# EUROPÄISCHE PATENTANMELDUNG

(11) **EP 1 463 201 A1**
(43) Veröffentlichungstag der Anmeldung: **29.09.2004**
(21) Anmeldenummer: 04005839.8
(22) Anmeldetag: 11.03.2004
(51) Int. Cl.: H03K 3/289, H03K 3/2885, H03K 3/356

(54) **Frequenzteiler-Anordnung mit Stromsignaleinspeisung**

(30) Priorität: 25.03.2003 DE 10313332
(71) Anmelder: Infineon Technologies AG, 81669 München (DE)
(72) Erfinder: Gossmann, Timo, 85579 Neubiberg (DE); Roithmeier, Andreas, 81547 München (DE); Lagies, Arrasch, South Burlington, VT 05403 (US)
(74) Vertreter: Epping, Hermann, Fischer

(57) **Zusammenfassung**

Schaltungsanordnung zur Frequenzteilung (2), aufweisend einen Eingang (E), dem ein getaktetes differentielles Eingangssignal (I_{P}, I_{N}) zuführbar ist, einen Ausgang, an dem ein getaktetes differentielles Ausgangssignal (I/IX, Q/QX) mit geteilter Frequenz abgreifbar ist, wobei das Eingangssignal als getaktetes Stromsignal ausgebildet ist.

## Beschreibung

Die Erfindung betrifft eine Schaltungsanordnung zur Frequenzteilung mit einem Eingang, dem ein getaktetes differentielles Eingangssignal zuführbar ist und einem Ausgang, an dem ein getaktetes differentielles Ausgangssignal mit geteilter Frequenz abgreifbar ist.

Integrierte Schaltungen für Telekommunikationseinrichtungen benötigen für ihre Arbeit eine Vielzahl von Signalen mit verschiedenen Taktfrequenzen. Daher wird meist aus Kostengründen an einer Stelle des integrierten Chips ein Signal erzeugt und dann an die verschiedenen Komponenten geliefert, die das Signal weiterverarbeiten. Bei Signalen mit anderer Frequenz als der zur Verfügung gestellten, ist es notwendig, eine entsprechende Frequenzteilung oder Frequenzsynthese vorzunehmen. Eine Frequenzteilung kann am einfachsten durch eine D-Flip-Flop-Schaltung erfolgen, die die Frequenz des Eingangssignals im Verhältnis 2:1 teilt. Eine komplexere Frequenzteilerschaltung zeigt die Druckschrift DE 100 43 953.

Darin wird ein Signal sowie das zugehörige invertierte Signal in zwei Differenzverstärkern eingekoppelt. Die beiden Differenzverstärker sind mit ihren Eingängen bzw. Ausgängen mit jeweils einem Hilfsausgang bzw. Hauptausgang gekoppelt. An diesen Ausgängen läßt sich ein Signal mit halber Eingangsfrequenz, sowie ein um 180° bzw. 90° verschobenes Signal abgreifen. Mit diesem Prinzip lassen sich verschiedene Frequenzteilerschaltungen realisieren.

Das Signal bzw. das invertierte Signal ist hier als Spannungssignal ausgebildet und liegt an der Basis eines jeweiligen Transistors an. Der Emitter dieser Transistoren ist mit weiteren Transistoren emitterseitig und einer Stromquelle verbunden, wobei der Kollektor mit einer Stromsenke verbunden ist. Durch das Anlegen einer Spannung an die Transistoren, die dem Signaltakt entspricht wird die Stromquelle gesteuert. Bei eingeschaltetem Transistor wird daher der Strom der Stromquelle in der Stromsenke verbraucht. Dieser Verbrauch führt zu einer lokalen Erwärmung sowie zu einem insgesamt höheren Leistungsverbrauch der gesamten Schaltung. Der Stromverbrauch kann dabei bis zu 25 % des Gesamtstroms betragen.

Die Aufgabe der Erfindung ist es daher, eine Anordnung vorzusehen, die eine Frequenzteilung bei geringerem Stromverbrauch ermöglicht.

Diese Aufgabe wird erfindungsgemäß durch die Merkmale des Patentanspruchs 1 gelöst. Vorteilhafte Weiterbildungen der Erfindung sind Gegenstand der Unteransprüche.

Dadurch daß eine Schaltungsanordnung vorgesehen ist, die einen Eingang und einen Ausgang aufweist, wobei dem Eingang ein differenzielles Taktsignal zugeführt wird und am Ausgang ein geteiltes Taktsignal abgreifbar ist, das eingangsseitig angelegte Taktsignal als getaktetes Stromsignal ausgebildet ist, ist das getaktete Stromsignal von der erfindungsgemäßen Schaltungsanordnung direkt verarbeitbar, ohne daß eine stromverbrauchende Strom/Spannungsumwandlung erfolgen muß.

In der Schaltungsanordnung wird das Stromsignal in der Frequenz geteilt und erst danach durch Strom/Spannungswandler in ein Spannungssignal umgesetzt. Dadurch wird der Stromverbrauch erheblich reduziert.

Die frequenzteilende Schaltungsvorrichtung kann vorteilhaft mehrere, ein Stromsignal verarbeitende Flip-Flop-Schaltungen aufweisen, die als Master/Slave-Schaltungen ausgebildet sind.

Eine vorteilhafte Weiterbildung ist es, wenn die Schaltungsanordnung symmetrische wirkende Schalter aufweist, die jeweils mit einem Eingang der Frequenzteilerschaltung verbunden sind. Dadurch läßt sich mit Hilfe der Schalter die Frequenzteilereinrichtung ein- bzw. ausschalten.

Sind die Schalter mit MOS-Transistoren ausgebildet, so läßt sich der Schalter vorteilhaft leistungslos realisieren. Zur Unterstützung der Schaltungseigenschaft können die Schalter weitere MOS-Transistoren unterschiedlichen Dotierungstyps aufweisen.

Für eine erfindungsgemäße Weiterbildung kann eine Vorrichtung zur Erzeugung eines differenziellen Stromsignals vorgesehen sein, das eingangsseitig mit einer Stromquelle und zur Takterzeugung des Ausgangssignals mit einem spannungsgesteuerten Oszillator verbunden ist.

Im Folgenden soll die Erfindung anhand von Ausführungsbeispielen näher erläutert werden. Es zeigen:
- Figur 1: ein erstes Ausführungsbeispiel der Erfindung,
- Figur 2: eine Weiterbildung des ersten Ausführungsbeispiels
- Figur 3: eine Schaltungsanordnung der stromverarbeitenden Frequenzteilereinrichtung,
- Figur 4: ein Diagramm mit Zuständen der Eingangs- bzw. Ausgangssignale gemäß der Frequenzteilerschaltung der Figur 3.

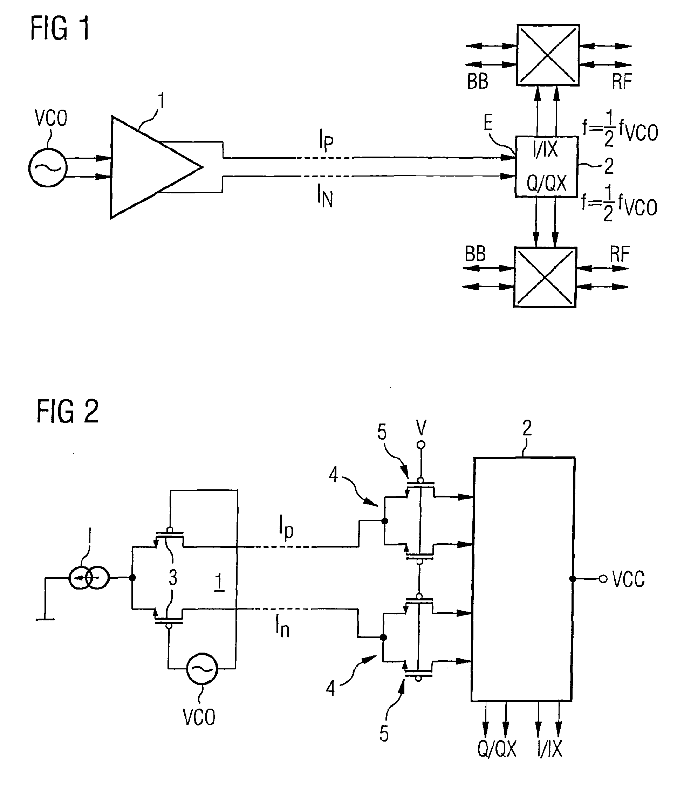

Figur 1 zeigt den schematischen Aufbau der Erfindung. Ein Taktsignal eines spannungsgesteuerten Oszillators VCO wird in einer Vorrichtung 1 in ein differenziertes Stromsignal I_{P}, I_{N} umgewandelt. Das differenzierte Stromsignal ist an dem Eingang E einer erfindungsgemäßen Frequenzteilerschaltung 2 angelegt.

Die Frequenzteilerschaltung 2 weist die beiden Ausgänge I und Q sowie die dazu invertierten Ausgänge IX und QX auf. Das an den Ausgängen I/IX und Q/QX abgreifbare Signal besitzt die halbe Frequenz des Eingangssignals I_{P}, I_{N}. Zusätzlich ist das Signal am Ausgang I und am Ausgang Q um 90° gegeneinander phasenverschoben. Die Ausgangssignale werden im vorliegenden Fall als Lokaloszillatorsignal zur Frequenzumsetzung verwendet.

Eine konkrete Ausführungsform der Erfindung ist in Figur 2 zu sehen. Gleiche Elemente tragen gleiches Bezugszeichen. Auf eine Erläuterung bereits bekannter Elemente wird verzichtet. Das differenzierte Stromsignal I_{P} und I_{N} wird durch die Schaltung 1 erzeugt. Hierzu ist die Schaltung 1 eingangsseitig mit einer Stromquelle I verbunden. Zwei symmetrische MOS-Transistoren 3 sind eingangsseitig mit der Stromquelle I verbunden. Die beiden Gate-Anschlüsse sind mit einem den Takt bereitstellenden spannungsgesteuerten Oszillator VCO verbunden. Die Transistoren 3 arbeiten somit als Schalter und erzeugen an ihren Drain-Ausgängen das differentielle, mit der Oszillatorfrequenz getaktete Stromsignal I_{P}, I_{N}.

Das getaktete Stromsignal gelangt an zwei symmetrisch arbeitende Schalter 4 und von dort aus in die Frequenzteilerschaltung 2, die als Master/Slave Flip-Flop-Schaltung ausgebildet ist. Jeder Schalter besteht jeweils aus zwei MOS-Transistoren 5, deren Gate-Anschlüsse mit einer Bias-Spannung V versorgt werden. Durch die Bias-Spannung V lassen sich die Transistoren 5 als Schalter verwenden. Anstatt der beschriebenen Frequenzteilerschaltung 2 können auch andere Schaltungen eingesetzt werden, die direkt Stromsignal verarbeiten können.

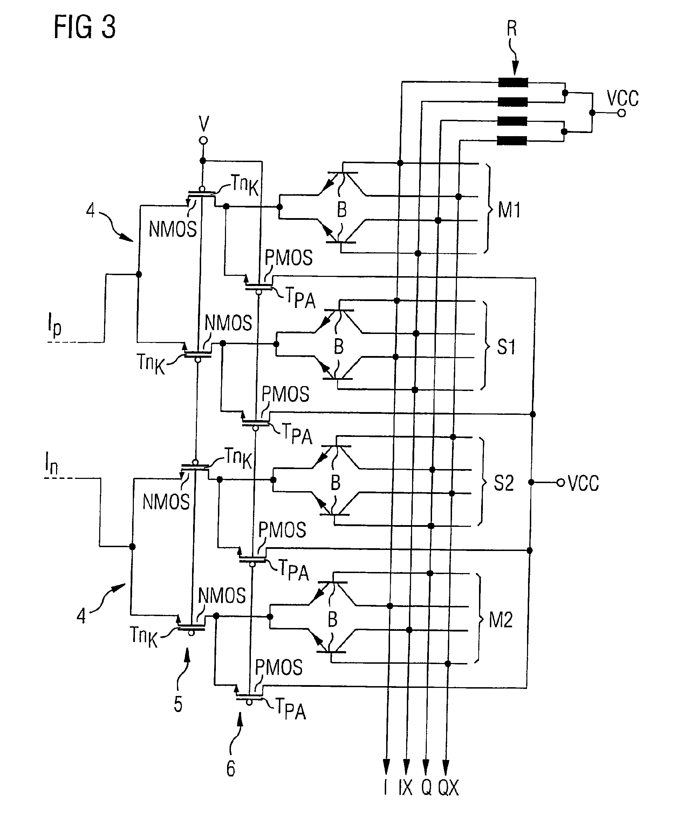

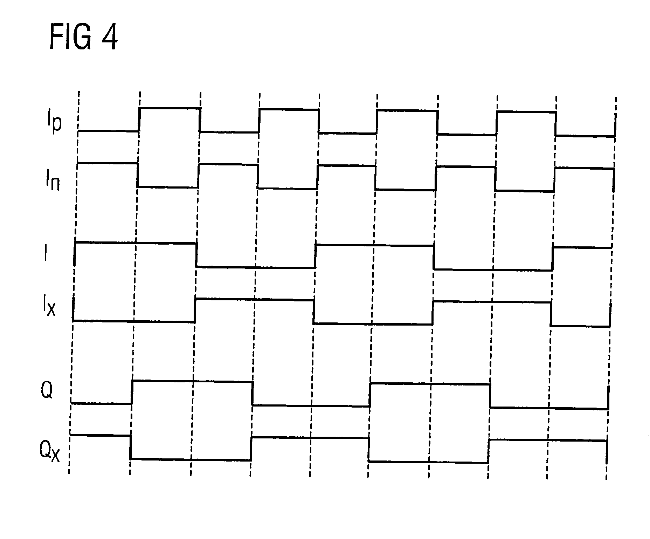

Ein Ausführungsbeispiel, das ein getaktetes Stromsignal zur Frequenzteilung verwendet, ist in Figur 3 zu sehen. Die dazugehörige Figur 4 zeigt ein Zustandsdiagramm des getakteten Eingangssignals sowie die dazugehörigen Ausgangssignale. Die Schaltungsanordnung erzeugt aus dem Eingangssignal I_{P} und dem dazu invertierten Eingangssignal I_{N} die Ausgangssignale I und Q mit der jeweils halben Frequenz des Eingangssignals und die dazugehörigen invertierten Signale IX und QX. Zusätzlich weisen die Ausgangssignale I und Q eine Phasenverschiebung von 90° gegeneinander auf.

Die Frequenzteilerschaltung der Figur 3 weist zwei Master/Slave Flip-Flop-Schaltungen M1/S1 und M2/S2 auf, die aus Bipolar-Transistoren B gebildet sind. Der Emitterausgang jedes Bipolar-Transistors B ist mit dem Drain-Ausgang der MOS-Transistoren 5, die als NMOS-Typ ausgebildet sind, verbunden. Je zwei MOS-Transistoren 5 führen mit ihrem Source Anschluß zur Signalleitung I_{P} oder I_{N}. Die Gate-Anschlüsse der Schalter Tn_{K} sind mit einer Bias-Spannung V verbunden. Zur Unterstützung des Schaltereffektes weist die Schaltung vier zusätzliche PMOS-Transistoren 6 auf. Deren Source-Kontakt ist mit dem Drain-Kontakt der Transistoren 5 bzw. dem Emitterausgang eines jeden Bipolar-Transistors B verbunden. Der Source-Ausgang der PMOS-Transistoren 6 führt zu einer Versorgungsspannung VCC. Die Gate-Anschlüsse Tp_{A} der PMOS-Transistoren 6 sind parallel zu den Gate-Anschlüssen Tn_{K} der NMOS-Transistoren 5 geschaltet. Dadurch unterstützen sie vorteilhaft ein Ab- bzw. Anschalten der Frequenzteileranordnung je nach angelegter Bias-Spannung V.

Eine Versorgungsspannung VCC, die über Widerstände R mit den Basiseingängen bzw. Emitter-Ausgängen der Bipolar-Transistoren B, sowie den Ausgängen I, IX, Q und QX verbunden ist, versorgt die Transistoren B mit der notwendigen Spannung. Durch die vorliegende Schaltung wird eine Frequenzteilung um den Faktor zwei sowie eine Phasenverschiebung von 90° zwischen dem I- und dem Q-Signal erreicht.

Ist eingangsseitig ein Taktsignal I_{P} angelegt, so hält die mit S1 bezeichnete Flip-Flop-Anordnung die Signale I und IX. Die beiden Transistoren B der Schaltung M1 erzeugen am Ausgang Q bzw. QX das invertierte Signal von IX bzw. I.

Ist im darauffolgenden Takt der Eingang I_{N} aktiv, so hält die mit S2 bezeichnete Anordnung die Signale Q und QX. Die beiden Bipolar-Transistoren der Anordnung M2 invertieren die an ihren Eingängen Q und QX anliegenden Signale und geben sie an ihren Ausgängen I bzw. IX aus. Mit dieser Schaltung ergibt sich der in Figur 4 gezeigte Signalverlauf.

Das eingangsseitig angelegte getaktete Stromsignal wird durch die Flip-Flop-Schaltung verarbeitet und erst über die Widerstände R in ein Spannungssignal umgewandelt, so daß an den Ausgängen ein getaktetes Spannungssignal abgreifbar ist. Dadurch läßt sich der Stromverbrauch deutlich reduzieren.

### Bezugszeichenliste:

- (1) :: Anordnung zur Stromsignalerzeugung
- (2):: Frequenzteilerschaltung
- (3):: MOS-Transistoren
- (4):: Schalter
- (5) :: MOS-Transistoren
- (6) :: Unterstützungstransistoren
- (VCO):: spannungsgesteuerter Oszillator
- (I) :: Stromquelle
- (V):: Spannungsquelle
- (B):: bipolare Transistoren
- (VCC):: Versorgungsspannung
- (R):: Strom/Spannungswandler
- (M1,S1):: Master/Save Flip-Flop Schaltung
- (M2,S2):: Master/Save Flip-Flop Schaltung
- (I/IX, Q/QX):: Signalausgänge
- (Tn_{K}, Tp_{A}):: Gate-Anschluß

## Patentansprüche

1. Schaltungsanordnung zur Frequenzteilung (2), mit einem Eingang (E), dem ein getaktetes differentielles Stromeingangssignal (I_{P}, I_{N}) zuführbar ist, einem Ausgang, an dem ein getaktetes differentielles Ausgangssignal (I/IX, Q/QX) mit geteilter Frequenz abgreifbar ist, wobei die Frequenzteilerschaltung stromverarbeitend zur Frequenzteilung des diffretentiellen Stromeingangssignals (I_{P}, I_{N}) ausgebildet ist;
**dadurch gekennzeichnet, daß**
ein mit Feldeffekttransistoren ausgebildeter Schalter (4) vorgesehen ist, der dem Eingang (E) der Schaltungsanordnung zur Frequenzteilung (2) vorgeschaltet ist, und das getaktete Stromeingangsignal (I_{P}, I_{N}) schaltbar macht.

2. Schaltungsanordnung nach Anspruch 1 oder 2,
**dadurch gekennzeichnet, daß**
die Frequenzteilerschaltung (2) durch jeweils zwei Master / Slave Flip-Flop Schaltungen (M1/S1, M2/S2) ausgebildet ist.

3. Schaltungsanordnung nach Anspruch 1 oder 2,
**dadurch gekennzeichnet, daß**
die Frequenzteilerschaltung (2) durch bipolare Transistoren ausgebildet ist.

4. Schaltungsanordnung nach Anspruch 1,
**dadurch gekennzeichnet, daß**
der Schalter (4) mit symmetrischen MOS-Transistoren ausgebildet ist.

5. Schaltungsanordnung nach Anspruch 4,
**dadurch gekennzeichnet, daß**
der Schalter (4) zur Unterstützung des Schaltvorgangs weitere MOS-Transistoren (6) mit zu den symmetrischen MOS-Transistoren (5) entgegengesetzter Dotierungsart aufweist.

6. Schaltungsanordnung nach einem der vorherigen Ansprüche,
**dadurch gekennzeichnet, daß**
die Schaltung eine Differenzschaltung (1) zur Erzeugung eines getakteten differentiellen Stromsignal aufweist, die eingangsseitig mit einer Stromquelle (I) und zur Bildung des differentiellen Stromsignals mit einem spannungsgesteuertem Oszillator (VCO) verbunden ist.

7. Schaltungsanordnung nach einem der vorherigen Ansprüche,
**dadurch gekennzeichnet, daß**
die Frequenzteilerschaltung (2) einen Strom / Spannungswandler aufweist, der nach einer Frequenzteilung das geteilte Stromsignal in ein getaktetes Spannungssignal transformiert.
